# EUROPEAN PATENT APPLICATION

(11) **EP 2 966 681 A1**
(43) Date of publication of application: **13.01.2016**
(21) Application number: 14176283.1
(22) Date of filing: 09.07.2014
(51) Int. Cl.: H01L 25/16, H01L 23/051, H01L 25/18, H01L 23/48, H01L 25/07, H01L 29/739, H01L 29/74, H01L 29/06, H01L 29/423

(54) **Power semiconductor devices**

(71) Applicant: GE Energy Power Conversion Technology Ltd, Rugby Warwickshire CV21 1BU (GB)
(72) Inventor: Brueckner, Thomas, 80804 Munich (DE); Jakob, Roland, 12277 Berlin (DE); Crane, Allan David, RUGBY, Warwickshire CV21 1BU (GB)
(74) Representative: Serjeants LLP

(57) **Abstract**

The invention relates to a press-pack power semiconductor device (1). The device (1) includes a centrally located wafer-type power semiconductor assembly (200) and a plurality of gate controlled die-type power semiconductor assemblies (100) arranged in at least one array around the periphery of the wafer-type power semiconductor.

## Description

### Field of the Invention

The present invention relates to power semiconductor devices, and in particular to switching devices for use in power converters where fault tolerance, high power density, efficiency, availability and low cost are required.

The power semiconductor devices can have a fail-safe mode of operation.

### Background Art

Press-pack semiconductor devices are used in high-power, medium and high voltage converters, and the pressure contact, thermo-mechanical-electrical interfaces that they employ are effective in providing the highest possible power ratings from a single semiconductor device of any particular type. Conventional thyristors, thyristor derivatives and diodes are available as press-pack devices where one (typically round) silicon wafer is compressed between two malleable metallic pole pieces. A protective housing surrounds the wafer and is hermetically sealed to the pole pieces. The compressed interfaces between respective pole pieces and wafer contact surfaces provide the lowest possible electrical contact resistance and resistance to heat transfer from wafer to external cooling devices (e.g., heatsinks). Thermal expansion compensation discs are typically inserted between respective pole piece and wafer contact surfaces in order to provide the greatest possible thermal cycling and thermal shock withstand.

Conventional high power thyristors, thyristor derivatives and diodes employ a single circular wafer in order to minimise the proportion of wafer area that is assigned to electric field edge termination and passivation; this area detracts from the proportion of wafer area that is available for conduction when the device is carrying current. It will be readily appreciated that it is convenient and cost-effective for diode and thyristor type semiconductor structures to employ simple bevelled edge termination techniques. The radial width of such a bevelled edge termination region, in providing a voltage grading function, is approximately proportional to the required wafer voltage blocking capability. Non-bevelled edge termination techniques may be employed in order to reduce the radial width of the edge termination region but they not normally preferred as they unreasonably complicate the otherwise simple diode and thyristor type semiconductor structures. The space that is occupied by edge termination features is increasingly significant as required voltage blocking capability increases and is generally considered to be a critical aspect of wafer design at voltages greater than about 3 kV. In practice, such devices beneficially employ a current carrying area that closely approaches that of the contact surface area of each pole piece. Large area circular wafers are therefore desirable from the perspective of current density and "on" state power loss minimisation within the current carrying area, with respect to a particular wafer area and a particular wafer voltage blocking capability. Conversely, current density may be expressed in terms of the current that a device can carry, relative to its total wafer area and, in these terms, circular wafers may be said to offer maximum achievable current density. Large area circular wafers are also desirable from a manufacturing cost perspective in circumstances where wafer manufacturing yield is not a critical consideration, as is the case for thyristor, non-mesa contacting thyristor derivative and diode wafers etc. These devices, in addition to having the highest possible continuous thermal ratings, also have the highest possible surge current ratings as a result of the combination of the above described geometric features and the beneficial features of their semiconductor topology.

Inverse parallel connected combinations of thyristors, thyristor derivatives and diodes have been coaxially monolithically integrated on the same wafer and housed as press-pack devices. The reverse conducting asymmetric thyristor and reverse conducting IGCT (integrated gate-commutated thyristor) are important examples of coaxially monolithically integrated press-pack devices as they have been used in voltage source inverters wherein the conduction periods of respective diode and thyristor derivative elements of a particular device are interleaved. In these exemplary devices, the respective current carrying areas of diode and thyristor derivative elements may be apportioned according to their pulse width modulated conduction duty cycles. These devices benefit from the use of a single annular edge termination region as described above, but also require a narrow ring type interposing edge termination region to be inserted between diode and thyristor derivative elements of the wafer. In practice the interposing edge termination has minimal impact upon the ratio between total current carrying area and pole piece area, and the benefits of monolithic integration upon converter packaging dominate over any disadvantage.

IGBTs (insulated gate bipolar transistors) have features that are desirable in the context of high power pulse width modulated and voltage source inverters. Their MOS (metal-oxide-semiconductor) gate structure provides fast and energy-efficient switching responses at turn on and turn off and these are achieved whilst requiring a relatively low gate drive current. Their bipolar transistor elements provide a low conduction power loss and a beneficial short circuit current limiting effect, particularly when combined with a suitable gate driver protection strategy. These benefits are achieved as a consequence of the use of a relatively complex multicellular semiconductor structure wherein each cell is very small and must have a precise geometry. This complexity is such that the IGBT designer must optimise the design with respect to factors such as the trade-off between performance, manufacturing yield and cost. The power semiconductor industry addressed this trade off by using a process wherein a large semiconductor wafer contains many small IGBT die structures. The individual die structures are separated after wafer processing and sub-standard die are discarded. Each die structure is inherently rectangular or square. By this means, the effect of a single local defect does not result in the loss of the whole wafer (as would be the case for a large thyristor or diode). Each die structure must include an electric field edge termination with passivation and, despite the use of modern planar techniques such as guard rings and field control rings, the current carrying area of each die is significantly less than the die area. It will be readily appreciated that planar edge termination techniques rely upon semiconductor fabrication processes that are far more sophisticated and expensive than those used for diode and thyristor type devices, but the processing requirements associated with the cellular IGBT structure are such as to facilitate the use of planar edge termination. Nevertheless, space that is occupied by edge termination features is increasingly significant as required voltage blocking capability increases and is generally considered to be a critical aspect of wafer design at voltages greater than about 1.5 kV.

IGBTs have been produced using press-pack housings and they comprise multiple parallel connected die structures since the maximum die size is limited to about 1-2 cm² and a total IGBT current carrying area of greater than 50 cm² may be required. Parallel connection of die in a press-pack housing is complicated, costly and rarely makes fully effective use of pole piece area or even the full die area, i.e., the ratio between the total semiconductor current carrying area and the pole piece heatsink contact area tends to be far less than unity. In many cases, there is a requirement to connect a diode in inverse parallel with an IGBT and an IGBT device may contain such a diode in the same press-pack housing, this being realised in the same manner as the IGBT, typically by using a number of parallel connected diode die. Stray inductance and clamping pressure constraints make it disadvantageous to realise an inverse parallel connected combination of IGBT and diode using separate press-pack IGBT and press-pack diode components. Accordingly, in order to achieve practically useful power ratings, it is usual practice for a number of IGBT die and a number of diode die to be distributed within the same-press-pack housing. The IGBT die and the diode die are rectangular and are typically square. Often the diode die and the IGBT die are of different sizes and the two types of die are interleaved within a rectangular array of die. IGBT die and diode die thickness matching or adaptation must be employed.

In one practical press-pack IGBT implementation, a rectangular array of interleaved IGBT die and diode die are distributed within a rectangular press-pack housing with rectangular pole pieces. This has the effect of optimising the packing density of the rectangular die within the outline of the press-pack device. It is difficult to achieve a uniform distribution of clamping pressure in this press-pack arrangement as a result of the bulk modulus and deformation of pole pieces, heatsinks and clamping hardware. Unless precautionary measures are taken to implement components that properly distribute clamping pressure over the die, there is a tendency for the die that are nearest to the corners of the housing to suffer from a reduction in clamping pressure that may compromise thermo-mechanical-electrical interfaces.

In another practical press-pack IGBT implementation where a rectangular array of interleaved IGBT die and diode die are distributed within a rectangular press-pack housing, sub-assemblies each comprising a number of IGBT die and diode die are provided with a dedicated spring loaded rectangular pole piece arrangement and a number of such sub-assemblies are assembled within a common rectangular housing. The press-pack device is clamped between two heatsinks and external clamping force is increasingly applied, whilst compressing the dedicated spring loaded arrangements until the heatsinks are in firm contact with the walls of the rectangular housing, thereby defining the clamping pressure on each die. As a consequence of the spring loading arrangement, heat may only effectively be removed from one side of the die (the second heatsink may be used to cool the next device in a stack of such devices). The spring loading arrangement is complex, expensive and results in under-utilisation of the die.

In yet another practical press-pack IGBT implementation, a rectangular array of interleaved IGBT die and diode die, or a rectangular array of IGBT die, or a rectangular array of diode die, are distributed within a circular press-pack housing with circular pole pieces, thereby failing to optimise the packing density of the rectangular die within the outline of the press-pack device. Internal surfaces of the pole pieces are profiled in order to achieve a uniform distribution of clamping pressure in this press-pack arrangement.

In addition to the above-described coaxial monolithic integration approach, it is known to integrate discrete rectangular die with a large area circular wafer type thyristor derivative device in an arrangement wherein the circular wafer is held in compression between pole pieces and an annular ring of non-compression mounted, low voltage MOSFET (metal oxide semiconductor field effect transistor) die is used in connection with a thyristor gate turn off process. In this case, the MOSFET die are mounted outside the diameter of the cathode-side pole pieces and these die may be mounted either outside or within an enlarged press-pack housing. The MOSFET die do not carry current during the conduction period of the central wafer, nor do they withstand the "off" state voltage of the thyristor derivative wafer. This device is known as the MOS controlled thyristor (MCT). The MCT is generally used in combination with an inverse parallel connected press-pack diode. It was proposed that the MOSFETs of the MTO would in future be monolithically integrated within the thyristor derivative wafer, i.e., within the current carrying area of the circular wafer and not in an annular ring of die, but this proved to be non-viable.

The principle of the MTO was further developed into the first generation emitter turn off thyristor (ETO) wherein additional MOSFETs were incorporated in the annular ring of non-compression mounted die that surrounded the cathode-side pole piece and the thyristor cathode current was directed to flow in the additional MOSFETs using a complex, expensive and thermally disadvantageous arrangement of copper plates. An annular ring of non-compression mounted MOSFET die surrounds the cathode-side pole piece and the cathode-side thermal interface continues to be compromised in the most recent evolutions of the ETO.

It is known to parallel connect a press-pack asymmetric thyristor (ASCR) with a conventional flat pack IGBT module comprising relatively fragile wire bonded, non-compression mounted IGBT and diode die, in order to provide an alternative path for current in the event that the IGBT module fails to function properly, thereby mitigating the risk of bond wire fuse blowing and module case explosion.

### Summary of the Invention

The present invention overcomes the conflicts between requirements that affect switching devices for use in power converters, and in particular the attainment of fault tolerance, high power density, efficiency, availability and low cost.

The present invention provides a power semiconductor device comprising:
a centrally located wafer-type power semiconductor assembly; and
a plurality of gate controlled die-type power semiconductor assemblies arranged in at least one array around the periphery of the wafer-type power semiconductor.

The wafer-type assembly can have any suitable shape and the die-type assemblies are preferably arranged around the wafer-type assembly in a correspondingly shaped array.

The wafer-type assembly is preferably substantially circular such that the die-type assemblies are arranged around the wafer-type assembly in at least one circumferential array. But it will be readily appreciated that the wafer-type assembly can also be polygonal-shaped, it being particularly advantageous, from a packing density perspective, for such a wafer outline to have a number of chord edges that corresponds with the number of die-type assemblies in the adjacent array. Although not generally preferred, the wafer-type assembly can be rectangular or square shaped such that the die-type assemblies are arranged around the wafer-type assembly in at least one square or rectangular array.

The wafer-type assembly can have compression contact interfaces.

Each die-type assembly can have compression contact interfaces.

The wafer-type device can be designed to have the intended current rating of the power semiconductor device.

The power semiconductor device will typically further include two pole pieces (e.g., a cathode-side pole piece and an anode-side pole piece) and an outer housing similar to a conventional press-pack device. Each pole piece will normally be positioned adjacent a corresponding heat sink in use. The pole pieces and outer housing can be appropriately sized and shaped to contain the central wafer-type assembly and the array of die-type assemblies. Each pole piece can include a central or radially inner region that is substantially aligned with the wafer-type assembly and an annular or radially outer region that is substantially aligned with the at least one array of die-type assemblies. If the die-type assemblies are arranged in two or more arrays, each pole piece can include a corresponding number of annular or radially outer regions, each annular or radially outer region being substantially aligned with a respective array of die-type assemblies.

In a first arrangement, the wafer-type assembly is a diode and the die-type assemblies are insulated gate bipolar transistor (IGBT) die. The diode is cost-effective and has a high power density as a result of its simple, robust construction, high manufacturing yield and ideal circular form which maximises current carrying area. Accordingly, the diode may conveniently be optimised from both steady state and transient thermal perspectives. The diode may be conveniently designed to have a particularly high surge current rating, for example. The nature of failure modes of large area circular wafer-type diodes, in having a high probability of attaining an electrical resistance that is comparable to their normal effective "on" state resistance, is known to be particularly beneficial in the context of applications wherein series redundancy is employed and there is a requirement for the failed device to continue to carry normal operating current without overheating or experiencing case rupture or explosion. The IGBT die are also cost effective and they are particularly effectively employed in the present invention in as much as they are disposed in an arrangement that provides thermo-mechanical and electromagnetic symmetry, whilst still being acceptably closely spaced. More particularly, this thermo-mechanical and electromagnetic symmetry is applicable to both the diode and the IGBT die. Such symmetry is beneficial in terms of steady state and transient operating conditions of the IGBT die. Whilst it is understood that when conventional IGBT die are disposed in a rectangular array they may benefit from having parallel geometric relationships between edges of adjacent die and therefore that they may be closely spaced, such rectangular arrays do not benefit from either thermo-mechanical or electromagnetic symmetry.

In a second arrangement, the wafer-type assembly is a hybrid device, preferably having a central or radially inner gate controlled region (e.g., a thyristor, thyristor derivative or asymmetric thyristor (ASCR) region) which is surrounded by an annular or radially outer diode region, and the die-type assemblies are IGBT die. In addition to providing all of the benefits of the first arrangement, the second arrangement provides an extremely robust and reliable gate controlled protective function where the gate controlled region may have a non-rupturing surge current rating that is many times in excess of the combined rating of the IGBT die. This non-rupturing functionality may be provided as a result of the combination of the regenerative structure of the gate controlled region and its central location within the hybrid device, it being the case that this region is completely embedded within the pole pieces and thermal compensation plates (or discs).

It is known for circular wafer-type press-pack devices to have limit case failure modes that are associated with housing rupture when extremely high surge currents are permitted to flow and the likelihood of such explosions has been shown to be correlated with the location of the initial failure site on the wafer, peripheral failure sites of course having the greatest likelihood of explosive behaviour since they lack the mechanical protection of confinement between pole pieces. The second arrangement therefore benefits in having the periphery of the gate controlled region confined well within the extremity of the central pole piece region which approaches the outer diameter of the diode region.

As used herein, the term "wafer-type assembly" might generally be taken to refer to an assembly that is processed as a single, often substantially circular, crystalline wafer whose diameter is many times its thickness and the term "die-type assembly" might generally be taken to refer to an assembly that is one of many identical such assemblies that are initially processed as part of a wafer and are subsequently separated, the separation process often dictating that the die be of rectangular or square format.

The faces of the wafer-type assembly are compressed between the corresponding central or radially inner regions of the pole pieces and the faces of the die-type assemblies are compressed between the corresponding annular or radially outer regions of the pole pieces. Means can be provided to alleviate any thickness variation between the individual die-type assemblies and between the die-type assemblies and the wafer-type assembly.

The periphery of each pole piece can be hermetically sealed to a wall of the outer housing.

Gate drive terminals for the power semiconductor device can pass through the housing wall and can be hermetically secured thereto.

The interfaces between the pole pieces and the wafer-type assembly may employ interposing thermal compensation plates (or discs). If the wafer-type assembly incorporates a central or radially inner gate controlled region and an annular or radially outer diode region, the thermal compensation plate (or disc) on the gate contact side of the wafer-type assembly may benefit from a depression or recess whose position corresponds with that of the ring of passivation material that separates the radially inner and outer regions of the wafer-type assembly and it may incorporate a clearance opening for a gate contact. When such a gate contact is used, a clearance opening in the thermal compensation plate (or disc) may be provided. The clearance opening in the thermal compensation plate (or disc) may correspond with a passage that is provided in the associated pole piece for the purpose of providing a route for the electrical conductor or wire that is used to interconnect the gate contact with the respective gate terminal on the outer housing wall. When the wafer-type assembly incorporates a gate controlled region this may benefit from gate drive pressure type contact which may be provided using any convenient device. In the particular case of a hybrid device with an ASCR region, an ASCR cathode auxiliary terminal may be provided on the periphery of the ASCR cathode-side pole piece and this terminal may be located close to the ASCR gate terminal in order to minimise the gate drive loop inductance.

The interfaces between the pole pieces and the die-type assemblies may also employ interposing thermal compensation plates. The gate-side thermal compensation plates may each incorporate a recess to facilitate the respective gate contact and a region upon which the respective emitter auxiliary contact may be made. Gate drive and emitter auxiliary contacts may be provided for each die-type assembly using any convenient device and pressure contact types are preferred. The gate contacts of each die-type assembly can be connected to a surrounding (e.g., annular) gate interconnection structure. The gate contacts for the die-type assemblies may be interconnected with one another and the respective gate terminal on the outer housing wall using any convenient means but the use of a printed circuit board (PCB) is generally preferred. The emitter auxiliary contacts for the die-type assemblies may be similarly interconnected. The interconnecting means may include a gate damping resistor for each die-type assembly and these damping resistors may be connected between the respective gate contact and the point of common coupling between all gate drive interconnections. The damping resistors are preferably PCB mounted. The point of common coupling between all gate drive interconnections gate may in turn be interconnected with the gate drive terminal on the outer housing wall. The point of common coupling between all emitter auxiliary interconnections may in turn be interconnected with the emitter auxiliary terminal on the outer housing wall.

Gate drive interconnections may be closely electromagnetically coupled with corresponding return current paths using any convenient means. The respective thicknesses of all components that are compressed between the two pole pieces may be precisely thickness matched by any convenient method. The wafer-type assembly may be precisely centrally located and the surrounding die-type assemblies may be precisely located in at least one coaxial circumferential array using any suitable location means.

As discussed herein, an objective of the present invention is that the central wafer-assembly shall not be damaged to the extent that press-pack case rupture or explosion will result following exposure of the device to extremely high surge current and the following aspects of design may be incorporated in order to satisfy this objective. When the wafer-assembly includes a gate contact, this contact and associated interconnecting wire may be insulated from, and sealed to, the surrounding thermal compensation plate (or disc) and pole piece in order to prevent leakage of gas or molten material into the housing in the event of device failure or intentional gate controlled turn on, in combination with an extremely high surge current. The wafer-type assembly is compressed between thermal compensations plates (or discs) and whereas the thermal compensation plate (or disc) on the anode-side of the diode (and also on the gate side of the thyristor or thyristor derivative when a thyristor or thyristor derivative region is incorporated within the wafer-type assembly) will generally be retained in position by locating means, and additionally by compressive forces, the other thermal compensation plate (or disc) may employ either the same locating means or an alloyed construction may be used. Alloyed construction defines that the wafer-type assembly is permanently joined to the thermal compensation plate (or disc) by an intermetallic or alloyed region. Alloyed construction is beneficial in allowing the thermal compensation plate (or disc) to provide improved mechanical support for the outer extremity of the relatively fragile wafer-type assembly and in reducing both interfacial thermal and electrical resistance, these factors combining to increase the non-rupturing surge current withstand of the press-pack device. Non-alloyed wafer interfaces are known as floating interfaces. A wafer having floating interfaces on both surfaces is known as a fully floating wafer.

The wafer-type assembly and the die-type assemblies of the power semiconductor device may each be fabricated using any applicable starting material, for example silicon or silicon carbide. The wafer-type assembly and die-type assemblies may be fabricated using different respective starting materials, for example the wafer-type assembly may be a silicon wafer and the die-type assemblies may be silicon carbide die.

Although the central wafer-type assembly has been described in terms of it comprising at least a diode and in some cases a hybridisation of a diode region with a thyristor derivative, other devices or combinations of devices that provide the same functionality may be used. The diode may be of any convenient topology and these topologies may be bipolar or unipolar. Although the die-type assemblies have been described as being IGBTs, other devices that provide the same or equivalent or improved functionality may be used. For example, the die-type assemblies may optionally be silicon or silicon carbide field effect transistors and these may optionally employ metal oxide insulated gates (MOSFET) or junction type gates (JFET). If JFETs are employed, they may be operated in conventional unipolar mode or they may be operated with gate current injection in order to benefit from a combination of unipolar and bipolar conduction (in this respect the JFET might be more correctly termed a static induction transistor (SIT).

### Drawings

Figure 1 shows plan and sectional views of an IGBT assembly with associated thermal compensation plates;
Figure 2 shows plan and sectional views of a fast recovery diode assembly with alloyed cathode-side interface;
Figure 3 shows plan and sectional views of an antiparallel hybridised fast recovery diode and asymmetric thyristor assembly with alloyed diode cathode-side and ASCR anode-side interfaces;
Figure 4 shows a part sectional view of a fast recovery diode assembly or hybridised fast recovery diode and asymmetric thyristor assembly with a fully floating wafer;
Figure 5 shows plan and sectional views of a first power semiconductor device according to the present invention;
Figure 6 shows plan and sectional views of a second power semiconductor device according to the present invention; and
Figure 7 shows partial plan and sectional views of a third power semiconductor device according to the present invention.

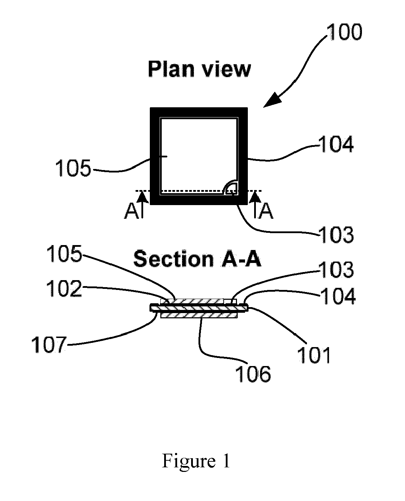

Figure 1 shows an IGBT assembly 100 including an industry-standard IGBT die 101, emitter contact metallisation 102, gate contact metallisation 103, passivation 104, emitter-side thermal compensation plate 105, collector-side thermal compensation plate 106, and collector contact metallisation 107.

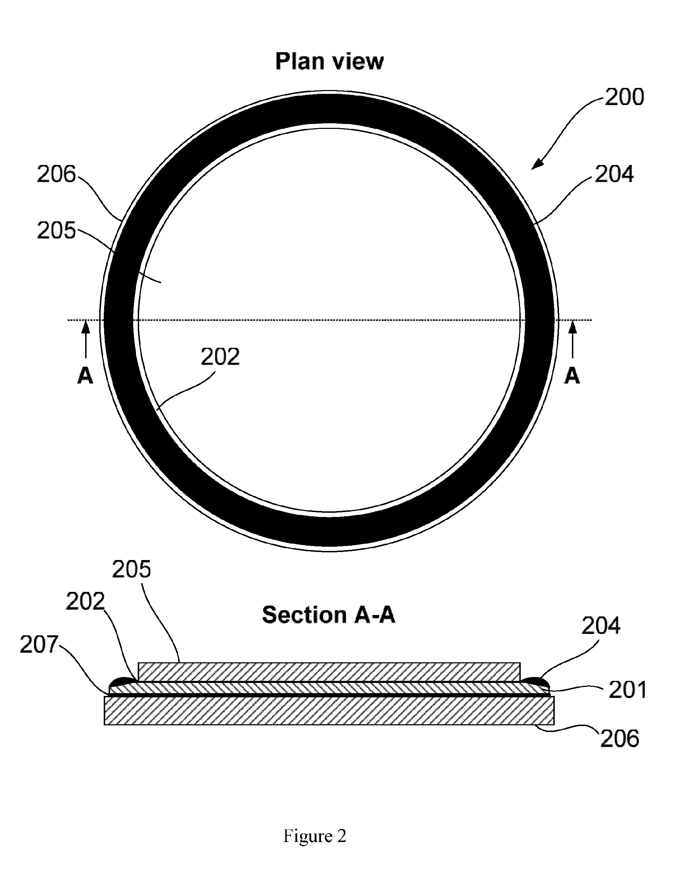

Figure 2 shows a fast recovery diode assembly 200 including a diode wafer 201, anode contact metallisation 202, passivation 204, anode-side thermal compensation disc 205, cathode-side thermal compensation disc 206 and cathode-side alloyed interface 207.

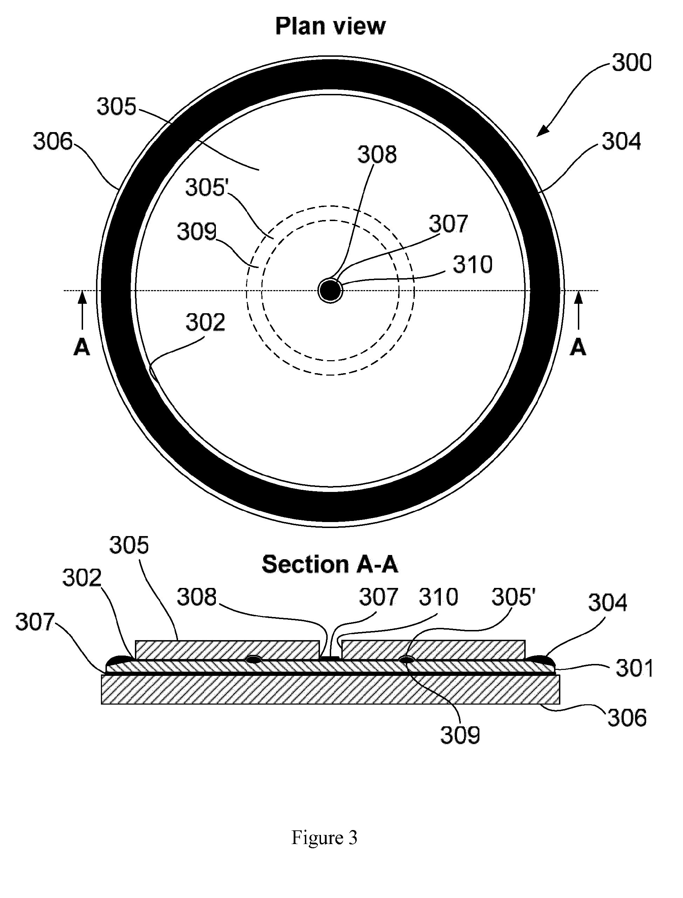

Figure 3 shows an antiparallel hybridised fast recovery diode and asymmetric thyristor (ASCR) assembly 300 including a hybrid diode/ASCR wafer 301, diode anode-side contact metallisation 302, diode passivation 304, diode anode-side/ASCR cathode-side thermal compensation disc 305, diode cathode-side/ASCR anode-side thermal compensation disc 306, ASCR gate contact metallisation 307, and ASCR cathode contact metallisation 308. The ASCR assembly 300 includes a diode cathode-side/ASCR anode-side alloyed interface. An annular recess 305' is provided in the thermal compensation disc 305. The position of the recess 305' corresponds with a ring of passivation material 309 that separates the radially inner ASCR region and the radially outer diode region. A clearance opening 310 for a gate contact is provided in the thermal compensation disc 305.

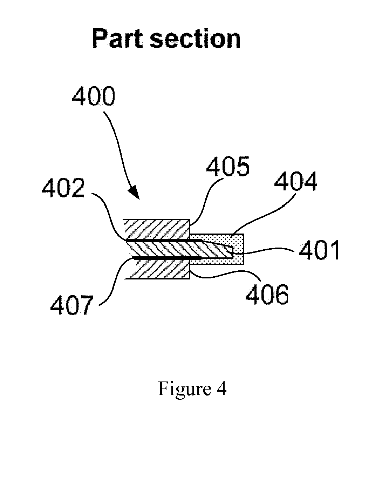

Figure 4 shows an alternative assembly 400 whose radially outermost edge includes a termination and passivation region. The assembly 400 includes a fully floating wafer 401, contact metallisation 402, 407, passivation 404, and thermal compensation discs 405, 406. Such an assembly can either be a fast recovery diode assembly of the type shown in Figure 2 or a hybridised diode and asymmetric thyristor assembly of the type shown in Figure 3.

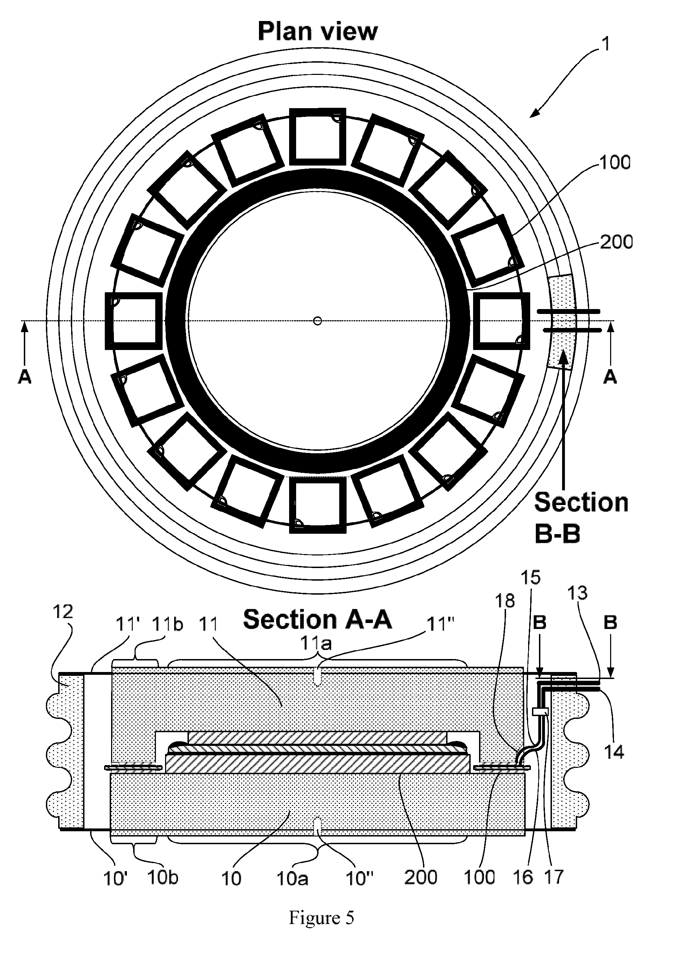

With reference to Figure 5, a first press-pack power semiconductor device 1 includes a radially inner fast recovery alloyed diode assembly 200 and a plurality of IGBT assemblies 100 arranged in a circumferential array around the periphery of the diode assembly. An alternative fully floating diode assembly 400 can also be used.

The device 1 also includes a diode cathode pole piece 10 which includes a flange 10' and a hole 10" for a roll pin or similar pin type locator whose position is fixed in the adjacent heatsink (not shown), and a diode anode pole piece 11 which includes a flange 11' and a hole 11 for a similar locator. The pole piece 10 has:
- a radially inner region 10a that is aligned with the diode assembly 200 and is in compressive contact with the cathode-side thermal compensation disc 206, and
- a radially outer region 10b that is aligned with the circumferential array of IGBT assemblies 100 and is in compressive contact with the collector-side thermal compensation plates 106.

The pole piece 11 also has:
- a radially inner region 11a that is aligned with the diode assembly 200 and is in compressive contact with the anode-side thermal compensation disc 205, and
- a radially outer region 11b that extends axially towards the pole piece 10 (i.e., such that the diode assembly 100 is located radially within the outer region), is aligned with the circumferential array of IGBT assemblies 100, and is in compression contact with the emitter-side thermal compensation plates 105.

The faces of the diode assembly 200 are therefore compressed between the corresponding radially inner regions 10a, 11 a of the pole pieces 10, 11 and the faces of the IGBT assemblies 100 are compressed between the corresponding radially outer regions 10b, 11b of the pole pieces.

The diode assembly 200 and the IGBT assemblies 100 are located within a press-pack outer housing with a wall 12 that is hermetically sealed to the flanges 10', 11' of the pole pieces 10, 11.

The device 1 includes an emitter auxiliary terminal 13 and a gate terminal 14 for the IGBT assemblies 100. Each individual IGBT assembly 100 includes an emitter auxiliary contact 15 and a gate contact 16 that are connected to the emitter contact metallisation 102 and the gate contact metallisation 103, respectively, and to an interface printed circuit board (PCB) 17. The interface PCB 17 is located between the anode pole piece 11 and the wall 12 of the outer housing. The emitter auxiliary contact 15 and the gate contact 16 pass through an opening or recess 18 in the anode pole piece 11. As shown in Figure 5, the IGBT assemblies 100 are disposed with all emitter auxiliary contacts 15 and gate contacts 16 in the same rotational position relative to the central axis of the device 1. But in practice any or all of the IGBT assemblies may be rotated by any convenient number of 90° increments in order to simplify the provision of emitter auxiliary and gate interconnections with the interface PCB 17.

The emitter auxiliary terminal 13 and gate terminal 14 are connected to the interface PCB 17 and extend through the wall 12 of the outer housing as shown in Figure 5.

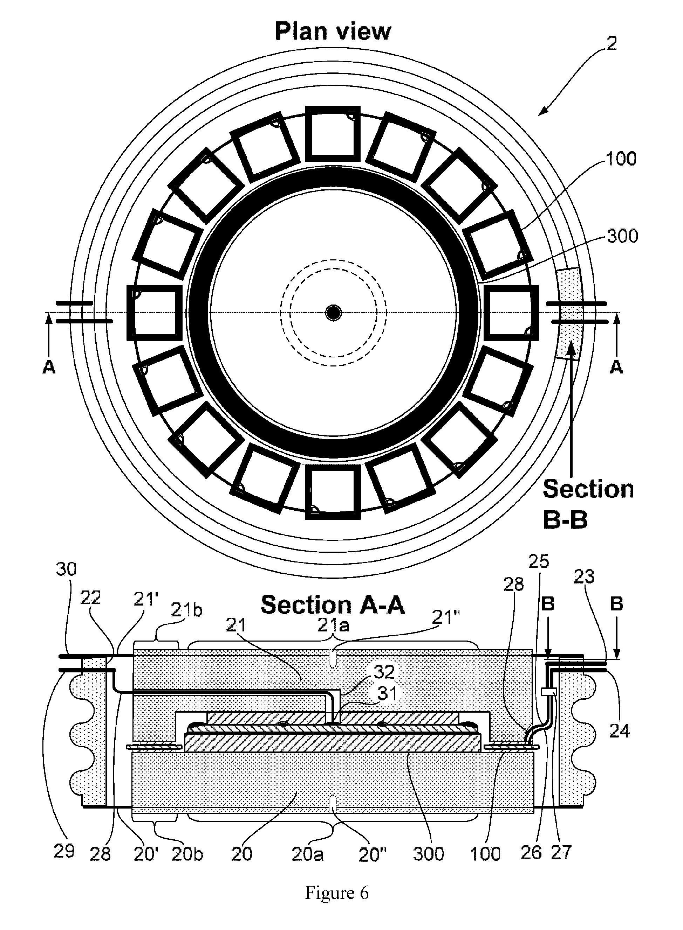

With reference to Figure 6, a second press-pack power semiconductor device 2 includes a radially inner hybrid diode/ASCR assembly 300 and a plurality of IGBT assemblies 100 arranged in a circumferential array around the periphery of the hybrid diode/ASCR assembly.

The device 2 also includes a diode cathode/ASCR anode pole piece 20 which includes a flange 20' and a hole 20" for a roll pin or similar pin type locator whose position is fixed in the adjacent heatsink (not shown), and a diode anode/ASCR cathode pole piece 21 which includes a flange 21' and a hole 21" for a similar locator. The pole piece 20 has:
- a radially inner region 20a that is aligned with the diode/ASCR assembly 300 and is in compressive contact with the diode cathode-side/ASCR anode-side thermal compensation disc 306, and
- a radially outer region 20b that is aligned with the circumferential array of IGBT assemblies 100 and is in compressive contact with the collector-side thermal compensation plates 106.

The pole piece 21 also has:
- a radially inner region 21a that is aligned with the diode/ASCR assembly 300 and is in compressive contact with the diode anode-side/ASCR cathode-side thermal compensation disc 305, and
- a radially outer region 21b that extends axially towards the pole piece 20 (i.e., such that the diode/ASCR assembly 300 is located radially within the outer region), is aligned with the circumferential array of IGBT assemblies 100, and is in compressive contact with the emitter-side thermal compensation plates 105.

The faces of the diode/ASCR assembly 300 are therefore compressed between the corresponding radially inner regions 20a, 21a of the pole pieces 20, 21 and the faces of the IGBT assemblies 100 are compressed between the corresponding radially outer regions 20b, 21b of the pole pieces.

The hybrid diode/ASCR assembly 300 and the IGBT assemblies 100 are located within a press-pack outer housing with a wall 22 that is hermetically sealed to the flanges 20', 21' of the pole pieces 20, 21.

The device 2 includes an emitter auxiliary terminal 23 and a gate terminal 24 for the IGBT assemblies 100. Each individual IGBT assembly 100 includes an emitter auxiliary contact 25 and a gate contact 26 that are connected to the emitter contact metallisation 102 and the gate contact metallisation 103, respectively, and to an interface PCB 27. The interface PCB 27 is located between the pole piece 21 and the wall 22 of the outer housing and the emitter auxiliary contact 25 and the gate contact 26 pass through an opening or recess 28 in the anode pole piece that is aligned with the clearance opening 310 in the thermal compensation disc 305. As shown in Figure 6, the IGBT assemblies 100 are disposed with all emitter auxiliary contacts 25 and gate contacts 26 in the same rotational position relative to the central axis of the device 2. But in practice any or all of the IGBT assemblies may be rotated by any convenient number of 90° increments in order to simplify the provision of emitter auxiliary and gate interconnections with the interface PCB 27.

The emitter auxiliary terminal 23 and gate terminal 24 are connected to the interface PCB 27 and extend through the wall 22 of the outer housing as shown in Figure 6.

The device 2 also includes a gate terminal 29 and a cathode auxiliary terminal 30 for the ASCR. The gate terminal 29 extends through the wall 22 of the outer housing as shown in Figure 6. The ASCR includes a gate contact 31 that is connected to the gate contact metallisation 307 and passes through an opening or recess 32 in the pole piece 21.

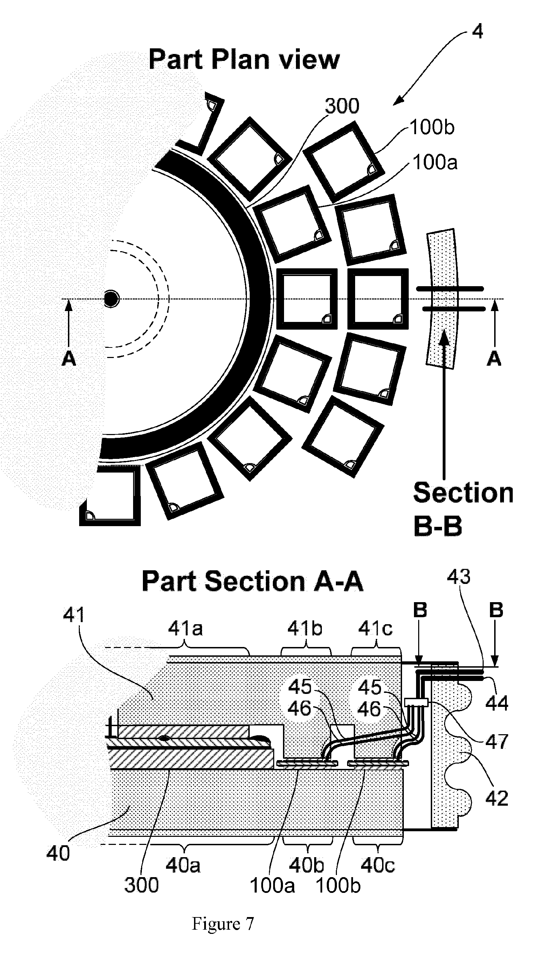

Although the first and second devices 1, 2 have a total of sixteen IGBT assemblies 100 arranged in a single circumferential array, it will be readily appreciated that any suitable number of IGBT assemblies can be provided. Figure 7 shows an alternative device 4 where the IGBT assemblies are arranged in two circumferential arrays, namely a first radially inner array of IGBT assemblies 100a adjacent the diode assembly 300 and a second radially outer array of IGBT assemblies 100b. The device 4 also includes a diode cathode/ASCR anode pole piece 40 and a diode anode/ASCR cathode pole piece 41. The pole piece 40 has:
- a radially inner region 40a that is aligned with the diode/ASCR assembly 300 and is in compressive contact with the diode cathode-side/ASCR anode-side thermal compensation disc 306,
- a first radially outer region 40b that is aligned with the first radially inner circumferential array of IGBT assemblies 100a and is in compressive contact with the collector-side thermal compensation plates 106, and
- a second radially outer region 40c that is aligned with the second radially outer circumferential array of IGBT assemblies 100b and is in compressive contact with the collector-side thermal compensation plates 106.

The pole piece 41 also has:
- a radially inner region 41a that is aligned with the diode/ASCR assembly 300 and is in compressive contact with the diode anode-side/ASCR cathode-side thermal compensation disc 305,
- a first radially outer region 41b that extends axially towards the pole piece 40 (i.e., such that the diode/ASCR assembly 300 is located radially within the outer region), is aligned with the first radially inner circumferential array of IGBT assemblies 100a, and is in compressive contact with the emitter-side thermal compensation plates 105, and
- a second radially outer region 41c that extends axially towards the pole piece 40, is aligned with the second radially outer circumferential array of IGBT assemblies 100b, and is in compressive contact with the emitter-side thermal compensation plates 105.

The faces of the diode/ASCR assembly 300 are therefore compressed between the corresponding radially inner regions 40a, 41a of the pole pieces 40, 41, the faces of the first radially inner array of IGBT assemblies 100a are compressed between the corresponding first radially outer regions 40b, 41b of the pole pieces, and the faces of the second radially outer array of IGBT assemblies 100b are compressed between the corresponding second radially outer regions 40c, 41c of the pole pieces.

The device 4 includes an emitter auxiliary terminal 43 and a gate terminal 44 for the IGBT assemblies 100. Each individual IGBT assembly 100a, 100b includes an emitter auxiliary contact 45 and a gate contact 46 that are connected to the emitter contact metallisation 102 and the gate contact metallisation 103, respectively, and to an interface PCB 47. The emitter auxiliary terminal 43 and gate terminal 44 are connected to the interface PCB 47 and extend through the wall 42 of the outer housing as shown in Figure 7. The IGBT assemblies 100 are disposed with all emitter auxiliary contacts 45 and gate contacts 46 in the same rotational position relative to the central axis of the device 4. But in practice any or all of the IGBT assemblies may be rotated by any convenient number of 90° increments in order to simplify the provision of emitter auxiliary and gate interconnections with the interface PCB 47. The interface PCB 47 may optionally be divided into two concentric rings (not shown) in order to simplify the provision of emitter auxiliary and gate interconnections within the PCB.

## Claims

1. A power semiconductor device (1; 2; 4) comprising:
a centrally located wafer-type power semiconductor assembly (200; 300; 400); and
a plurality of gate controlled die-type power semiconductor assemblies (100; 100a, 100b) arranged in at least one array around the periphery of the wafer-type power semiconductor (200; 300; 400).

2. A power semiconductor device (1; 2; 4) according to claim 1, wherein the wafer-type assembly (200; 300; 400) includes compression contact interfaces and/or each die-type assembly (100; 100a, 100b) includes compression contact interfaces.

3. A power semiconductor device (1; 2; 4) according to claim 1 or claim 2, wherein the wafer-type assembly is a diode (200; 400) or a hybrid device (300; 400), the hybrid device (300; 400) optionally including a central or radially inner gate controlled region which is surrounded by an annular or radially outer diode region.

4. A power semiconductor device (1; 2; 4) according to any preceding claim, wherein the die-type assemblies are insulated gate bipolar transistor (IGBT) die (100; 100a, 100b), silicon or silicon carbide field effect transistors optionally employing metal oxide insulated gates (MOSFETs) or junction type gates (JFETs).

5. A power semiconductor device (1; 2; 4) according to any preceding claim, further comprising two pole pieces (10, 11; 20, 21; 40, 41), each pole piece including a central or radially inner region (10a, 11a; 20a, 21a; 40a, 41a) that is aligned with the wafer-type assembly (200; 300; 400) and at least one annular or radially outer region (10b, 11b; 20b, 21b; 40b, 40c, 41b, 41c) that is aligned with the at least one array of die-type assemblies (100; 100a, 100b).

6. A power semiconductor device (1; 2; 4) according to claim 5, wherein the interfaces between the pole pieces (10, 11; 20, 21; 40, 41) and the wafer-type assembly (200; 300; 400) employ interposing thermal compensation plates (205, 206; 305, 306; 405, 406).

7. A power semiconductor device (2; 4) according to claim 6, wherein the wafer-type assembly (300; 400) incorporates a central or radially inner gate controlled region and an annular or radially outer diode region, and wherein the thermal compensation plate (305) on the gate contact side of the wafer-type assembly (300; 400) includes:
(i) a recess (305') whose position corresponds substantially with that of a ring of passivation material (309) that separates the radially inner and outer regions of the wafer-type assembly (300; 400), and/or
(ii) a clearance opening (310) for a gate contact.

8. A power semiconductor device (1; 2; 4) according to any of claims 5 to 7, wherein the interfaces between the pole pieces (10, 11; 20, 21; 40, 41) and the die-type assemblies (100; 100a, 100b) employ interposing thermal compensation plates (105, 106).

9. A power semiconductor device (1; 2; 4) according to any preceding claim, wherein each die-type assembly (100; 100a, 100b) includes a gate contact (15; 25; 45) and an emitter auxiliary contact (16; 26; 46).

10. A power semiconductor device (1; 2; 4) according to claim 9, wherein the gate contacts (15; 25; 45) for the die-type assemblies (100; 100a, 100b) are interconnected with one another connected to a gate terminal (13; 23; 43) by interconnection means (17; 27; 47).

11. A power semiconductor device (1; 2; 4) according to claim 9 or claim 10, wherein the emitter auxiliary contacts (16; 26; 46) for the die-type assemblies (100; 100a, 100b) are interconnected with one another and connected to an emitter auxiliary terminal (14; 24; 44) by interconnection means (17; 27; 47).

12. A power semiconductor device (1; 2; 4) according to claim 10 or claim 11, wherein the interconnection means is a printed circuit board (17; 27; 47).

13. A power semiconductor device according to any of claims 10 to 12, wherein the interconnection means includes a gate damping resistor for each die-type assembly and wherein the damping resistors are connected between the respective gate contact and the point of common coupling between all gate contact interconnections.

14. A power semiconductor device (1; 2; 4) according to any preceding claim, wherein the wafer-type assembly (200; 300) has an alloyed construction.

15. A power semiconductor device according to any of claims 1 to 13, wherein the wafer-type assembly (400) has a non-alloyed construction, optionally a fully-floating construction.
